Europäisches Patentamt

European Patent Office

Office européen des brevets

(19)

(11) Publication number: **0 431 900 A2**

(12) **EUROPEAN PATENT APPLICATION**

(21) Application number: **90313165.4**

(22) Date of filing: **04.12.90**

(51) Int. Cl.⁵: **H03H 11/04**

(30) Priority: **04.12.89 JP 315817/89**

(43) Date of publication of application:
**12.06.91 Bulletin 91/24**

(84) Designated Contracting States:
**DE FR GB**

(71) Applicant: **NEC CORPORATION
7-1, Shiba 5-chome Minato-ku
Tokyo 108-01 (JP)**

(72) Inventor: **Kagawa, Shigeru
c/o NEC Corporation, 7-1, Shiba 5-chome
Minato-ku, Tokyo (JP)**

(74) Representative: **Pritchard, Colin Hubert et al
Mathys & Squire 10 Fleet Street
London EC4Y 1AY (GB)**

(54) **Filter circuit.**

(57)    In a filter circuit, a reference-level generating circuit (1) is provided in which a reference signal is inputted. The reference-level generating circuit (1) converts a level of the reference signal. A first amplitude detector (2) is provided for detecting, in amplitude, the reference signal converted in level, from the reference-level generating circuit (1). The reference signal is inputted to a first filter unit (3) having a predetermined filtering characteristic. A second amplitude detector (6) is provided for detecting, in amplitude, an output from the first filter unit (3). An input signal is inputted to a second filter unit (6) having a predetermined filtering characteristic. An output from the first amplitude detector (2) and an output from the second amplitude detector (4) are inputted to a voltage comparator (5), to output a control voltage to the first and second filter units (3, 6), whereby the cut-off frequency ($f_0$) of the filter circuit is automatically controlled to a desired value.

FIG.1

EP 0 431 900 A2

# FILTER CIRCUIT

## BACKGROUND OF THE INVENTION

The present invention relates to filter circuits and, more particularly, to a filter circuit for use in an analog integrated circuit.

Conventionally, a filter circuit like one described above is provided with an adjusting resistor or the like externally connected to the filter circuit in order to cope with variation in capacitance of capacitors which are fabricated within an analog integrated circuit.

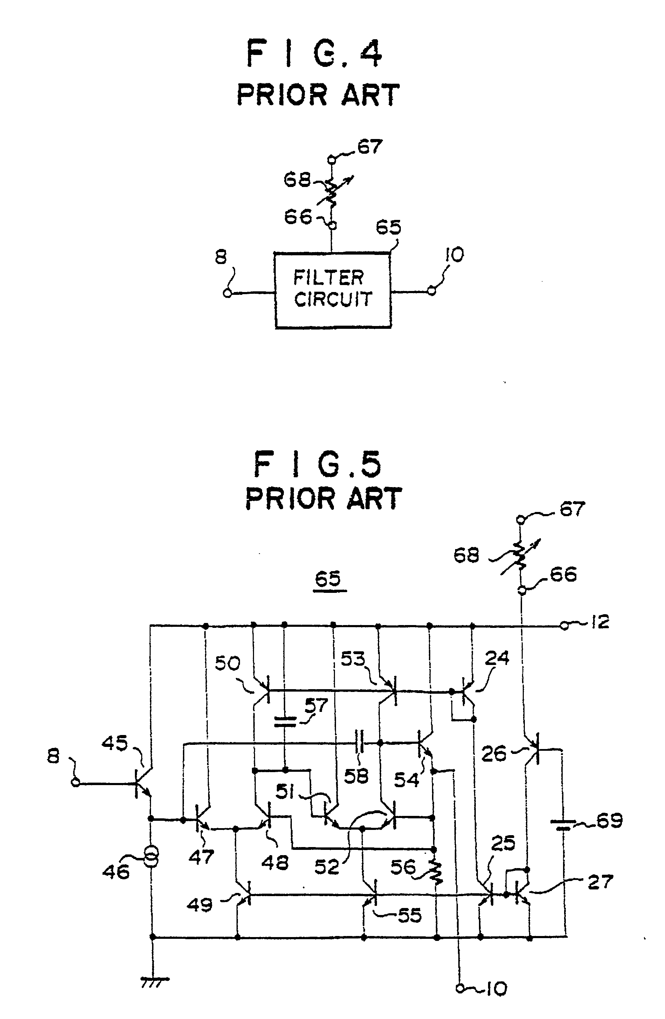

Fig. 4 is a block diagram of a filter circuit for explanation of an example of the conventional one.

As shown in Fig. 4, a conventional filter circuit 65 comprises an input terminal 8, an output terminal 10, a terminal 66 for adjusting cut-off frequency $f_o$ of the filter circuit 65, and a bias-voltage input terminal 67. A variable resistor 68 for adjusting $f_o$ is connected between the adjusting terminal 66 and the bias-voltage input terminal 67 so as to be able to adjust the cut-off frequency of the filter circuit 65. That is, an input signal inputted to the input terminal 8 is outputted from the output terminal 10 after having been subjected to a desired band-rejection in the filter circuit 65. At this time, the variable resistor 68 for adjusting $f_o$ is controlled to regulate the current flowing into the adjusting terminal 66, whereby the cut-off frequency $f_o$ of the filter circuit 65 can be adjusted.

Fig. 5 of the attached drawings is a detailed circuit diagram of the filter circuit 65 shown in Fig. 4.

As shown in Fig. 5, in the conventional filter circuit, a collector and a base of a transistor 45 are connected respectively to a power-voltage supply terminal 12 and the input terminal 8, and further an emitter of the transistor 45 is grounded through a constant-current source 46. A plurality of transistors 47, 48, 49 and 50 cooperate with each other so as to form a first differential amplifier. A base of the transistor 47, that is, a non-inverting input of the differential amplifier is connected to a common connecting point of the emitter of the aforesaid transistor 45 and one end of a capacitor 58. A connecting point of both the collectors of the transistors 48 and 50, which is an output of the first differential amplifier, is coupled to the power-voltage supply terminal 12 through a capacitor 57, and is also connected to a base of a transistor 51, that is, a non-inverting input of a second differential amplifier which is formed by a plurality of transistors 51, 52, 53 and 55. A connecting point of both the collectors of the transistors 52 and 53, that is, an output of the second differential amplifier, is connected to the other end of the capacitor 58 and a base of a transistor 54. Further, a collector of the transistor 54 is connected to the power-voltage supply terminal 12 and an emitter of the same is grounded through a resistor 56. The emitter of the transistor 54 is also connected to the base of the transistor 48, that is, the inverting input of the first differential amplifier, and is further connected to the base of the transistor 52, that is, the inverting input on the second differential amplifier. Furthermore, the emitter of the same transistor 54 is connected to the output terminal 10. On the other hand, in a constant-current biasing circuit which is formed by a plurality of transistors 24 through 27 and a DC voltage source 69, a base of the transistor 24, that is, a first output of the constant-current biasing circuit is connected to the respective bases of the transistors 50 and 53, each of which is a constant-current load for each of the first and second differential amplifiers. A base of the transistor 27, that is, a second output of the constant-current biasing circuit is connected to the respective bases of the transistors 48 and 55, each of which is a constant-current source for each of the first and second differential amplifiers. An emitter of the transistor 26 is coupled to the bias-voltage input terminal 67 through the $f_o$ adjusting terminal 66 and the $f_o$ adjusting resistor 68.

On the assumption that the transfer conductance of the first differential amplifier and that of the second differential amplifier are $g_{m1}$ and $g_{m2}$, respectively, and the capacitance of the capacitor 57 and that of the capacitor 58 are $C_{57}$ and $C_{58}$, respectively, transfer function T[S] from the input terminal 8 to the output terminal 10 of the overall filter circuit 65 can be expressed by the followig equation :

$$T[S] = \cfrac{S^2 + \cfrac{g_{m1}g_{m2}}{C_{57}C_{58}}}{S^2 + S\cfrac{g_{m2}}{C_{58}} + \cfrac{g_{m1}g_{m2}}{C_{57}C_{58}}} \qquad \ldots \ldots (1)$$

where $S = j\omega$, and $\omega = 2\pi f$.

As will be apparent from the above equation (1), the filter circuit 65 functions as a band-elimination circuit in which its cut-off frequency $f_o$ is expressed by the following equation :

$$f_o \approx \frac{1}{2\pi} \sqrt{\frac{g_{m1} g_{m2}}{C_{57} C_{58}}} \qquad \ldots \ldots (2)$$

Here, it is assumed that the current flowing through the first and second differential amplifiers, that is, the emitter current flowing through the respective transistors 47, 48, 51 and 52 is $I_{e1}$. Then, the following equation can be obtained :

$$g_{m1} = g_{m2} = \frac{1}{r_e} = \frac{I_{e1}}{V_T} \qquad \ldots \ldots (3)$$

In this equation,

$$Vt = \frac{kT}{q}$$

where $r_e$ is an emitter resistance ; $k$ is the Boltz-mann's constant ; $T$ is the absolute temperature ; and $q$ is an electric charge of electron.

Further, if the above equation (3) is substituted into the above equation (2) on the assumption that $C_{57} = C_{58} = C_1$ in relation to the capacitance $C_{57}$, $C_{58}$ of the capacitors 57 and 58, the following equation can be obtained :

$$f_o = \frac{I_{e1}}{2\pi C_1 V_T} \qquad \ldots \ldots (4)$$

In summary, in the case of the integrated circuit, the capacitance of the capacitor varies or fluctuates largely within a range of 5% to 15%. Accordingly, as will be seen from the above equation (4), the cut-off frequency $f_o$ also varies largely. Thus, in the conventional filter circuit, it is necessary to adjust the cut-off frequency $f_o$ by varying the $f_o$ adjusting resistor 68 which is externally connected to the integrated circuit and then by varying the emitter current $I_e$.

The above-described conventional filter circuit has the following disadvantage. That is, in the case where the capacitance of the capacitors within the integrated circuit varies, the cut-off frequency $f_o$ must be adjusted by the use of the variable resistor which is externally connected to the integrated circuit. Thus, an adjusting process or step is required.

## SUMMARY OF THE INVENTION

It is an object of the invention to provide a filter circuit in which the above-described adjusting process or step of the cut-off frequency can be dispensed with, and in which it is possible to realize a reduction in the number of assembling steps, an improvement in reliability, and a reduction in cost.

According to one aspect of the invention, there is provided a filter circuit comprising :—

a reference-level generating circuit into which a reference signal is inputted, the reference-level generating circuit converting a level of the reference signal ;

a first amplitude detector for detecting, in amplitude, the reference signal converted in level by the reference-level generating circuit ;

a first filter means into which the reference signal is inputted, the first filter means conducting a predetermined filtering operation on the reference signal ;

a second amplitude detector for detecting, in amplitude, an output from the first filter means ;

a second filter means into which an input signal is inputted, the second filter means conducting a predetermined filtering operation on the input signal ; and

a voltage comparator into which an output from the first amplitude detector and an output from the second amplitude detector are inputted, to output a control voltage to the first and second filter means.

With the above arrangement of the filter circuit according to the invention, a negative-feedback loop is formed by a combination of the reference-level generating circuit, the amplitude detecting circuit, the voltage comparator, and the first filter means in which the cut-off frequency $f_o$ is controlled in voltage. The second filter means which correlates with the first filter means is also provided for processing the signal. Thus, the following advantages can be produced. That is, even if the absolute value of capacitance of each of various capacitors within an integrated circuit varies so that the cut-off frequency $f_o$ varies, the cut-off frequency $f_o$ can automatically be controlled to a desired value. Accordingly, an adjustment of $f_o$ can be dispensed with, and it is possible to realize a reduction in the number of assembling steps of a set of an integrated circuit, an improvement in reliability, and a reduction in cost.

## BRIEF DESCRIPTION OF THE DRAWINGS

The above and other objects, features and advantages of the present invention will be apparent from the following description of preferred embodiments of the invention, with reference to the accompanying drawings, in which :—

Fig. 1 is a block diagram of a filter circuit for explanation of an embodiment of the invention ;

Fig. 2 is a detailed circuit diagram of a first exemplification of the filter circuit illustrated in Fig. 1 ;

Fig. 3 is a detailed circuit diagram of a second exemplification of the filter circuit illustrated in Fig 1 ;

Fig. 4 is a block diagram of a filter circuit for explanation of a conventional one : and

Fig. 5 is a detailed circuit diagram of the conventional filter circuit illustrated in Fig. 4.

## DETAILED DESCRIPTION

Throughout the following explanation, similar reference symbols or numerals refer to the same or similar elements in all figures of the drawings.

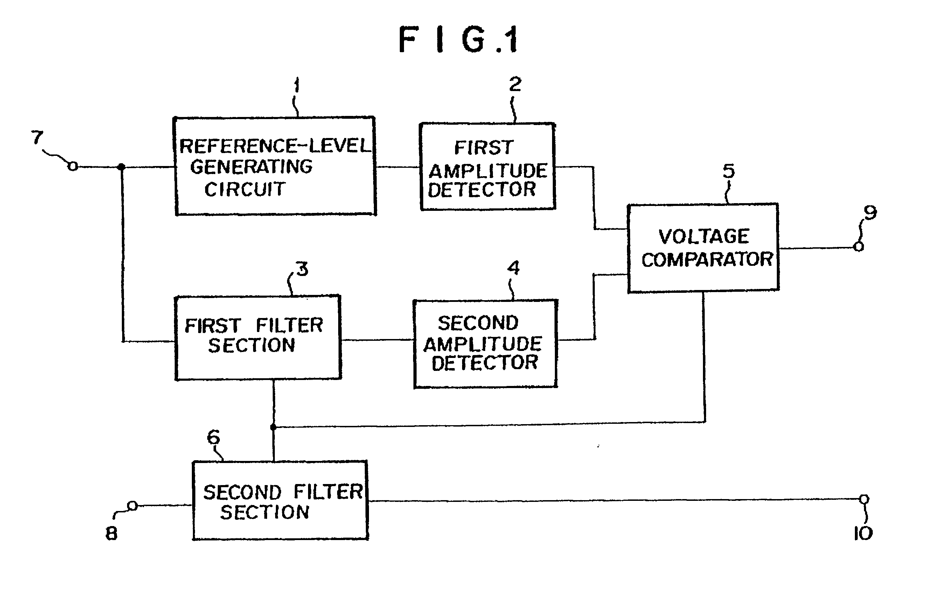

Referring first to Fig. 1, there is shown, in a block diagram, a filter circuit according to an embodiment of the invention.

As shown in Fig. 1, the filter circuit according to the embodiment comprises a reference-level generating circuit 1, a first amplitude detector 2, a first filter section 3, a second amplitude detector 4, a second filter section 6, and a voltage comparator 5. Specifically, a reference signal is inputted, from a reference-signal input terminal 7, to the reference-level generating circuit 1 where a level of the reference signal is converted into an adequate level. The first amplitude detector 2 detects, in amplitude, the converted reference signal from the reference-level generating circuit 1. The reference signal is also inputted to the first filter section 3. The first filter section 3 outputs an output signal after the reference signal having been subjected to a predetermined filtering operation. The second amplitude detector 4 detects, in amplitude, the output from the first filter section 3. An input signal is inputted to the second filter section 6 from an input terminal 8, and the second filter section 6 outputs an output after the input signal having been subjected to a predetermined filtering operation, from an output terminal 10. An output from the first amplitude detector 2 and an output from the second amplitude detector 4 are inputted to the voltage comparator 5 which outputs a control voltage to the first and second filter sections 3 and 6. The voltage comparator 5 also issues its output to a capacitor connecting terminal 9.

Specifically, the input of the reference-level generating circuit 1 is connected to the reference-signal input terminal 7, and the output of the reference-level generating circuit 1 is connected to the input of the first amplitude detector 2. The output of the first amplitude detector 2 is connected to one input of the voltage comparator 5. Further, the input of the first filter section 3 is connected also to the reference-signal input terminal 7, and the output of the first filter section 3 is connected to the input of the second amplitude detector 4. Furthermore, the output of the second amplitude detector 4 is connected to the other input of the voltage comparator 5. The output of the voltage comparator 5 is connected to control terminals of the respective first and second filter sections 3 and 6. The input of the second filter section 6 is connected to the input terminal 8, and the output thereof is connected to the output terminal 10.

The operation of the filter circuit constructed as above will be described below in detail.

First, when the reference signal which is applied to the reference-signal input terminal 7 is inputted to the reference-level generating circuit 1 and also to the first filter section 3, the reference signal is converted by the reference-level generating circuit 1 into a signal having a predetermined level. Subsequently, the converted reference signal is detected in amplitude by the first amplitude detector 2, and is supplied to one input of the voltage comparator 5. On the other hand, the reference signal inputted to the first filter section 3 is subjected to a predetermined attenuation operation. Subsequently, the attenuated reference signal is detected in ampli-

4

tude by the second amplitude detector 4, and is supplied to the other input of the voltage comparator 5. The voltage comparator 5 issues and forward the control voltage corresponding to a difference in output voltages between the first and second amplitude detectors 2 and 4, to the control terminals of the respective first and second filter sections 3 and 6.

Here, since the first filter section 3, the second amplitude detector 4 and the voltage comparator 5 all cooperate with each other to form a negative-feedback loop, a feedback operation is so effected that two input voltage values applied to the voltage comparator 5 are equalized to each other. That is, the cut-off frequency of the first filter section 3 is controlled such that the output level of the first filter section 3 is equalized to the output level of the reference-level generating circuit 1. Accordingly, if the first filter section 3 and the second filter section 6 are so constituted as to correlate with element dependency of the cut-off frequency, the output level of the second filter section 6 correlates with the output level of the reference-level generating circuit 1. Thus, the cut-off frequency of the second filter section 6 is also controlled.

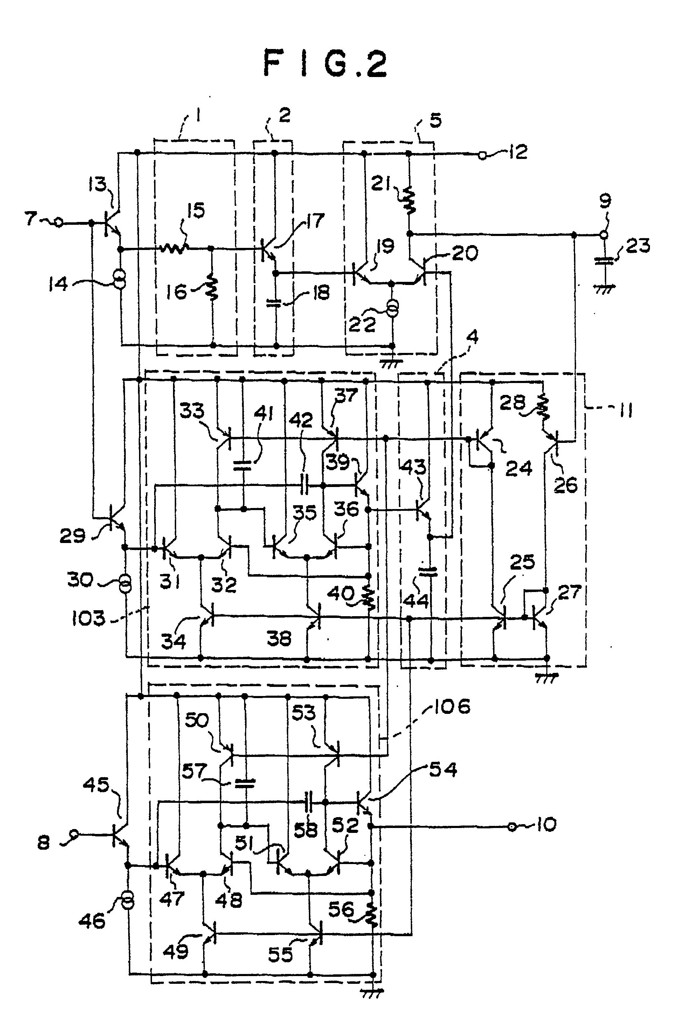

Referring next to Fig. 2, there is shown, in a detailed circuit diagram, a filter circuit according to a first exemplification of the invention. In this connection, components and parts like or similar to those illustrated in Fig. 1 are designated by the same or like reference numerals as in Fig. 2, and the description of the like or similar components and parts will be omitted or simplified to avoid duplication.

As shown in Fig. 2, the filter circuit according to the first exemplification is provided with an emitter-follower circuit which is formed by a transistor 13 and a constant-current source 14. The collector of the transistor 13 is connected to the power-voltage supply terminal 12. The emitter-follower circuit has an input side which is connected to the reference-signal input terminal 7. A chroma subcarrier signal is inputted to the reference-signal input terminal 7 as the reference signal. An output side of the emitter-follower circuit is connected to the input of the reference-level generating circuit 1 which is formed by a network circuit of two resistors 15 and 16. The output of the reference-level generating circuit 1 is connected to the input of the first amplitude detector 2 which is formed by a transistor 17 and a capacitor 18. The output of the first amplitude detector 2 is connected to the non-inverting input of the voltage comparator 5 which is formed by a pair of transistors 19 and 20, a load resistor 21 and a constant-current source 22. The output of the voltage comparator 5 is connected to the capacitor terminal 9 to which a capacitor 23 is connected. Furthermore, the output of the voltage comparator 5 is also connected to an input of a biasing circuit 11 which is formed by a plurality of transistors 24 through 27 and a resistor 28.

On the other hand, another emitter-follower circuit is provided which is formed by a transistor 29 and a constant-current source 30. An input side of this emitter-follower circuit is connected to the reference-signal input terminal 7. An output side of the emitter-follower circuit is connected to the input of the first filter section 103 serving as a chroma trap circuit which is formed by a plurality of transistors 31 through 39, a resistor 40 and two capacitors 41 and 42. The output of this first filter section 103 forming the chroma trap circuit is connected to the input of the second amplitude detector 4 which is formed by a transistor 43 and a capacitor 44. The output of the amplitude detector 4 is connected to the inverting input of the voltage comparator 5.

Likewise, the filter circuit according to the first exemplification is provided with a further emitter-follower circuit which is formed by a transistor 45 and a constant-current source 46. An input of this emitter-follower circuit is connected to the input terminal 8 to which a composite video signal as the input signal is inputted. An output of this emitter-follower circuit is connected to the input of the second filter section 106 serving as a chroma trap circuit which is formed by a plurality of transistors 47 through 55, a resistor 56 and two capacitors 57 and 58. The output of the second filter section 106 serving as the chroma trap circuit is connected to the output terminal 10 which outputs the video signal. The output of the aforesaid biasing circuit 11 is connected to each of the bases of the respective transistors 33, 34, 37 and 38 in the first filter section 103 and to each of the bases of the respective transistors 49, 50, 53 and 55 in the second filter section 106, in which the first and second filter sections 103 and 106 form their respective chroma trap circuits. That is, the output from the aforementioned biasing circuit 11 is connected to each bias input of the first and second filter sections 103 and 106.

The first and second filter sections 103 and 106, which respectively form the chroma trap circuits, are equivalent to the band-elimination circuit in the conventional filter circuit described and explained with reference to Fig. 5. Now, it is assumed that the emitter current flowing through the respective transistors 31, 32, 35 and 36 in the first filter section 103 and that flowing through the respective transistors 47, 48, 51 and 52 in the second filter section 106 are $I_{e2}$, and the capacitance of the respective capacitors 41 and 42 in the first filter section 3 and that of the respective capacitors 57 and 58 in the second filter section 6 are $C_2$. Then, from the aforesaid equation (4), the cut-off frequency $f_0$ of each of the first and second filter sections 103 and 106 forming the chroma trap circuits, can be expressed as follows :

$$f_0 = \frac{I_{e2}}{2\pi\,C_2 V_T} \qquad \ldots \quad \ldots \quad (5)$$

As described previously, the chroma subcarrier signal and the composite video signal are inputted respectively to the input terminals 7 and 8, and the video signal is out-putted from the output terminal 10. In this first exemplification, however, a feedback is conducted such that the inverting input voltage and the non-inverting input voltage applied to the voltage comparator 5 are equalized to each other. Accordingly, the cut-off frequency $f_0$ of the first filter section 103 is controlled such that the output level of the reference-level generating circuit 1 and the output level of the first filter section 103 serving as the chroma trap circuit are equalized to each other. Further, the first and second filter sections 103 and 108 serving as the chroma trap circuits respectively are connected to the common biasing circuit 11 and, furthermore, are identical with each other in their circuit arrangements. Accordingly, the cut-off frequency $f_0$ of the second filter section 106 is also controlled such that the output level of the reference-level generating circuit 1 and the output level of the second filter section 6 are to be the same with each other. Thus, by changing the relative resistance ratio between the resistors 15 and 16 and by setting the level of the non-inverting input of the voltage comparator 5 to a predetermined value, it is possible to control the cut-off frequency $f_0$ of the second filter section 106 to a desired value automatically.

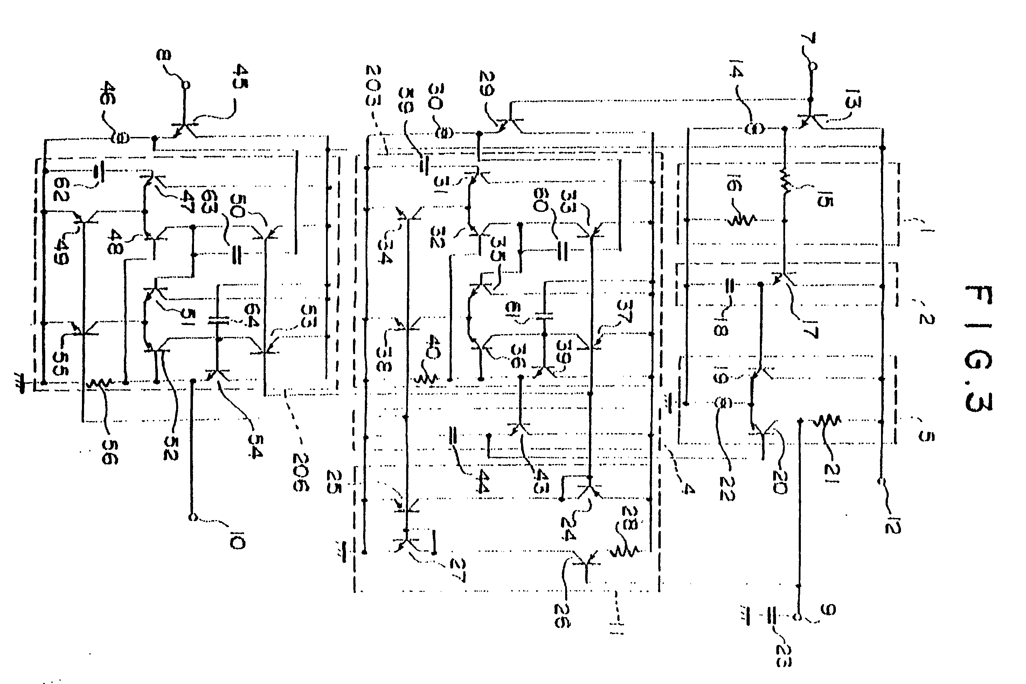

Referring next to Fig. 3, there is shown a filter circuit according to a second exemplification of the invention. In this connection, components and parts like or similar to those illustrated in Figs. 1 and 2 are designated by the same or like reference numerals in Fig. 3, and the description of the like or similar components and parts will be omitted or simplified to avoid repetition.

As shown in Fig. 3, the second exemplification is different from the aforesaid first exemplification in that chroma band-pass circuits instead of the band-elimination circuits in the latter are used in the filter circuit. Other arrangement and operation of the second exemplification are the same as those of the first exemplification. That is, the filter circuit of this second exemplification comprises a reference-level generating circuit 1, a first amplitude detector 2, a second amplitude detector 4, a biasing circuit 11, and a voltage comparator, each of which is identical in its construction to the corresponding circuit in the first exemplification shown in Fig. 2. A chroma subcarrier signal and a composite video signal are inputted respectively to the reference-signal input terminal 7 and the input terminal 8. A chroma signal is outputted from the output terminal 10.

Specifically, the filter circuit according to the second exemplification comprises first and second filter sections 203 and 206. In the first filter section 203, two capacitors 60 and 61 are employed in substitution for the capacitors 41 and 42 illustrated in Fig. 2. Further, a reference voltage source 59 is connected between the base of the transistor 31 and the ground. Likewise, in the second filter section 206, two capacitors 63 and 64 are employed in substitution for the capacitors 57 and 58 illustrated in Fig. 2. Furthermore, a reference voltage source 62 is connected between the base of the transistor 47 and the ground. These elements 59 through 64 are connected in the first and second filter sections 203 and 206 as illustrated in Fig. 3.

Similarly to the aforementioned first exemplification, the cut-off frequency $f_0$ of the first and second filter sections 203 and 206 can be obtained by the following equation :

$$f_0 = \frac{I_{e2}}{2\pi\,C_3 V_T} \qquad \ldots \quad \ldots \quad (6)$$

where $I_{e2}$ is emitter current flowing through the respective transistors 31, 32, 35, 36 in the first filter section 203 and the respective transistors 47, 48, 51, 52 in the second filter section 206 ; and $C_3$ is capacitance of each of the capacitors 60, 61 and 63, 64.

As the first and second exemplifications, it has been explained that the band-elimination circuits (103, 106) and the band-pass circuits (203, 208) for high frequency are employed as the first and second filter sections 3 and 6. However, the invention should not be limited to these exemplifications. That is, other than the band-elimination circuits or the band-pass circuits, low-pass filter circuits and high-pass filter circuits may be used. And further, band-pass filter circuits, band-elimination filter circuits, high-pass filter circuits and low-pass filter circuits for low frequency range may be employed and in which case a resistor is added to each of the emitter circuits of the differential amplifiers to reduce transfer conductance $g_m$.

While the invention has been described in its preferred embodiments, it is to be understood that the words which have been used are words of description rather than limitation and that changes within the purview of the appended claims may be made without departing from the true scope and spirit of the invention in its broader aspects.

## Claims

1. A filter circuit characterized by comprising :—

   a reference-level generating circuit (1) into which a reference signal is inputted, said reference-level generating circuit (1) converting a level of said reference signal ;

   a first amplitude detector (2) for detecting, in amplitude, said reference signal converted in level by said reference-level generating circuit ;

   a first filter means (3 ; 103 ; 203) into which said reference signal is inputted, said first filter means being for conducting a predetermined filtering operation on said reference signal ;

   a second amplitude detector (4) for detecting, in amplitude, an output from said first filter means (3 ; 103 ; 203) ;

   a second filter means (6 ; 106 ; 206) into which an input signal is inputted, said second filter means (4) being for conducting a predetermined filtering operation on said input signal ; and

   a voltage comparator (5) into which an output from said first amplitude detector and an output from said second amplitude detector are inputted, to output a control voltage to said first and second filter means.

2. A filter circuit according to claim 1, wherein each of said first and second filter means (3, 103, 203 ; 6, 106, 206) comprises a plurality of differential amplifiers (31, 32 ; 35, 36 ; 47, 48 ; 51, 52) said first and second filter means having cut-off frequency which is controlled by the electric current flowing through each of said differential amplifiers, and said first and second filter means being so arranged as to have correlation in element dependency with respect to said cut-off frequency.

3. A filter circuit according to claim 1, wherein each of said first and second filter means is in the form of a band-elimination filter circuit.

4. A filter circuit according to claim 1, wherein each of said first and second filter means is in the form of a band-pass filter circuit.

# F I G .1

REFERENCE-LEVEL GENERATING CIRCUIT (1)

FIRST AMPLITUDE DETECTOR (2)

VOLTAGE COMPARATOR (5)

FIRST FILTER SECTION (3)

SECOND AMPLITUDE DETECTOR (4)

SECOND FILTER SECTION (6)

7

9

8

10

EP 0 431 900 A2

# F I G.2

# F I G.3

# F I G. 4
## PRIOR ART

# F I G. 5
## PRIOR ART